# EUROPÄISCHE PATENTSCHRIFT

(11) **EP 0 532 781 B1**
(45) Veröffentlichungstag und Bekanntmachung des Hinweises auf die Patenterteilung: **03.06.1998**
(21) Anmeldenummer: 91115876.4
(22) Anmeldetag: 18.09.1991
(51) Int. Cl.: H03H 17/02

(54) **Integrierte Schaltungsanordnung mit einem analogen Netzwerk**
Integrated circuit comprising an analog circuit
Montage intégré comportant un circuit analogique

(43) Veröffentlichungstag der Anmeldung: 24.03.1993
(73) Patentinhaber: SIEMENS AKTIENGESELLSCHAFT, 80333 München (DE)
(72) Erfinder: Gazsi, Lajos, Dr., W-4000 Düsseldorf (DE)

(56) Entgegenhaltungen:
- US-A- 4 803 647
- US-A- 4 809 203
- IEEE JOURNAL OF SOLID-STATE CIRCUITS. Bd. SC21, Nr. 1, Februar 1986, NEW YORK US YANNIS TSIVIDIS U.A.: 'CONTINUOUS -TIME MOSFET-C FILTERS IN VLSI'
- PROC OF THE 37th ANNUAL FREQUENCY CONTROLSYMPOSIUM 1983; 1-3 JUNE 1983, PHILADELPHIA (US) P.371-375 :R. SCHAUMANN "MICROELECTRONIC ANALOG ACTIVE FILTERS"

## Beschreibung

Die Erfindung betrifft eine integrierbare Schaltungsanordnung mit einem analogen Netzwerk.

Netzwerke von hoher Genauigkeit mit Widerständen und Kapazitäten werden heutzutage überwiegend noch diskret oder in Hybridtechnik ausgeführt. Der schaltungstechnische Aufwand ist dabei sehr hoch, jedoch erfüllen diese Techniken bisweilen am besten die Anforderungen bezüglich absoluter Genauigkeit, Fertigungstoleranz, Langzeitstabilität und Temperaturverhalten (Siehe auch zum Beispiel US-A-4 809 203).

Netzwerke in integrierter Schaltungstechnik dagegen erfordern im allgemeinen einen sehr geringen schaltungstechnischen Aufwand. Sie haben aber den Nachteil, daß die damit erzeugten Widerstände und Kapazitäten starken fertigungsbedingten und temperaturabhängigen Schwankungen unterworfen sind. Eine hohe absolute Genauigkeit und eine hohe Konstanz ist nur mit erheblichem zusätzlichen Aufwand zuerzielen.

Bei M. Banu, Y. Tsividis, An Elliptic Continuous-Time CMOS-Filter With On-Chip Automatic Tuning, IEEE Journal of Solid-State Circuits, Vol. SC-20, No. 6, December 1985 und bei Y. Tsividis, M. Banu, J. Khoury, Continuous-Time MOSFET-C Filters in VLSI, IEEE Journal of Solid-State Circuits, Vol. SC-21, No. 1, February 1986 ist jedoch eine integrierbare Schaltungsanordnung mit einem Filter beschrieben, das zwar die üblichen Kapazitäten aufweist, bei dem aber die Widerstände durch MOS-Feldeffekttransistoren ersetzt werden. Die Ansteuerung der MOS-Feldeffekttransistoren erfolgt durch einen Phasendetektor, dem ein Schleifenfilter nachgeschaltet ist. Der Phasendetektor wiederum vergleicht ein Referenzsignal mit dem Ausgangssignal eines Oszillators oder mit dem Antwortsignal eines weiteren Filters, das durch das Referenzsignal angeregt wird.

Oszillator und weiteres Filter weisen MOS-Feldeffekttransistoren und Kapazitäten auf, die in gleicher Weise aufgebaut sind, wie die MOS-Feldeffekttransistoren und die Kapazitäten des einen Filters. Dabei wird davon ausgegangen, daß bei integrierter Schaltungstechnik anstelle einer hohen absoluten Genauigkeit eine hohe relative Genauigkeit zwischen zwei oder mehreren gleichartig aufgebauten Bauelementen erreicht wird. Der Oszillator oder das weitere Filter sind Bestandteil eines Phasenregelkreises, der bezüglich des Referenzsignals den Oszillator oder das weitere Filter über die MOS-Feldeffekttransistoren mit hoher absoluter Genauigkeit einstellt. Die MOS-Feldeffekttransistoren des einen Filters werden dabei mit den gleichen Signalen wie der Oszillator oder das weitere Filter angesteuert, so daß auch hier eine hohe absolute Genauigkeit erreicht wird.

Ein großer Anwendungsbereich für derartige analoge Netzwerke liegt insbesondere bei digitalen Signalverarbeitungseinrichtungen, die einschließlich der Analog-Digital-Wandler und Digital-Analog-Wandler voll integrierbar sind, bei denen vor- bzw. nachgeschaltete Analogfilter jedoch meist diskret aufgebaut werden müssen. Es wird daher angestrebt, auch die Analogfilter mit zu integrieren, wobei der Aufwand dafür möglichst gering sein sollte. Bei der bekannten Lösung ist der Aufwand beim Abgleichen des analogen Regelkreises jedoch sehr hoch.

Aufgabe der Erfindung ist es daher, eine integrierbare Schaltungsanordnung mit einem analogen Netzwerk anzugeben, die diesen Nachteil nicht aufweist.

Die Aufgabe wird gelöst durch eine Schaltungsanordnung gemäß Patentanspruch 1 oder 2. Ausgestaltungen und Weiterbildungen des Erfindungsgedankens sind in Unteransprüchen gekennzeichnet.

Die Erfindung wird nachfolgend anhand der in den Figuren der Zeichnung dargestellten Ausführungsbeispiele näher erläutert.

Es zeigt:
- Figur 1: eine erste Ausführungsform einer erfindungsgemäßen Schaltungsanordnung und
- Figur 2: eine zweite Ausführungsform einer erfindungsgemäßen Schaltungsanordnung.

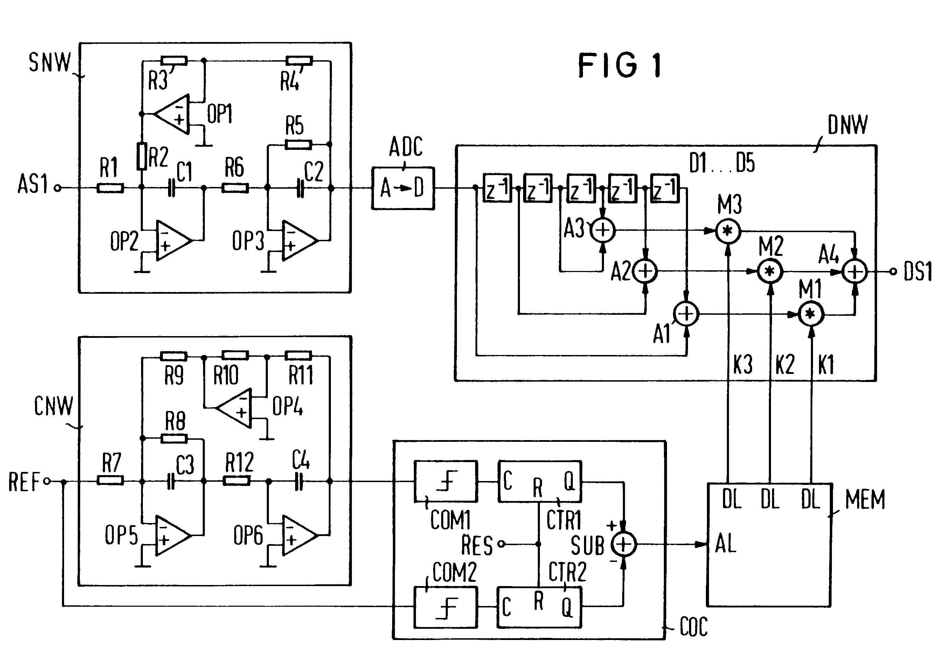

Eine erfindungsgemäße Schaltungsanordnung umfaßt gemäß Figur 1 der Zeichnung ein Widerstände R1...R6 und Kapazitäten C1, C2 aufweisendes analoges Signalnetzwerk SNW, einen diesem nachgeschalteten Analog-Digital-Wandler ADC und ein diesem wiederum nachgeschaltetes digitales Signalnetzwerk DNW mit einstellbaren Koeffizienten K1, K2, K3. Außerdem ist ein Widerstände R7...R12 und Kapazitäten C3, C4 aufweisendes analoges Vergleichsnetzwerk CNW vorgesehen, dessen Widerstände R7...R12 und Kapazitäten C3, C4 identisch zu den Widerständen R1...R6 und den Kapazitäten T1, T2 des analogen Signalnetzwerkes SNW aufgebaut sind und an das ein Anregungssignal angelegt ist. Schließlich enthält die erfindungsgemäße Schaltungsanordnung eine Auswerteschaltung COC, die ein vom analogen Vergleichsnetzwerk CNW aufgrund des Anregungssignals abgegebenes Antwortsignal mit einem Referenzsignal REF vergleicht und davon abhängig die Koeffizienten K1, K2, K3 des digitalen Signalnetzwerkes DNW einstellt.

Das Einstellen der Koeffizienten K1, K2, K3 erfolgt in Weiterbildung der Erfindung mittels eines zwischen Auswerteschaltung COC und digitales Signalnetzwerk DNW geschalteten Speichers MEM, in dem unterschiedliche Werte für die Koeffizienten K1, K2, K3 abgelegt sind. Bei der Einstellung der Koeffizienten K1, K2, K3 des digitalen Signalnetzwerkes DNW werden jeweils bestimmte Werte durch die Auswerteschaltung COC ausgewählt und dem digitalen Signalnetzwerk DNW übergeben. Über Adreßleitungen AL des Speichers MEM wird dazu von der Auswerteschaltung COC dem Speicher MEM ein Datenwort übermittelt, das eine bestimmte Adresse darstellt. Unter dieser Adresse ist im Speicher für jeden Koeffizienten K1, K2, K3 jeweils ein bestimmter Wert abgelegt, der daraufhin an das digitale Signalnetzwerk DNW über Datenleitungen DL ausgegeben wird.

Die Auswerteschaltung COC besteht aus einem digitalen Phasendetektor mit zwei Zählern CTR1, CTR2 sowie einem Subtrahierer SUB. Der Zähler CTR1 wird dabei mit dem Antwortsignal des Vergleichsnetzwerkes CNW und der Zähler CTR2 mit dem Referenzsignal REF angesteuert. Diese Signale sind jeweils an einen Zähleingang C der betreffenden Zähler CTR1, CTR2 gelegt. Die Ausgänge Q der beiden Zähler CTR1, CTR2 sind auf jeweils einen Eingang des Subtrahierers SUB geführt, dessen Ausgang mit den Adreßleitungen AL des Speichers MEM verschaltet ist. Die Reseteingänge R beider Zähler CTR1, CTR2 sind zusammengeführt und werden in bestimmten Zeitabständen durch ein Rücksetzsignal RES zurückgesetzt. Den beiden Zählern CTR1, CTR2 sind jeweils Komparatoren COM1, COM2 vorgeschaltet, um die Flankensteilheit der betreffenden Signale, insbesondere jedoch des Antwortsignals des Vergleichsnetzwerkes CNW, zu erhöhen.

Das Vergleichsnetzwerk CNW ist durch ein Bandpaßfilter mit drei Operationsverstärkern OP4, OP5, OP6 gegeben, deren nichtinvertierende Eingänge jeweils auf einem Bezugspotential liegen und die zwischen Ausgang und invertierendem Eingang gegengekoppelt sind. Dabei ist der Operationsverstärker OP4 über einen Widerstand R10, der Operationsverstärker OP6 über eine Kapazität C4 und der Operationsverstärker OP5 über eine Kapazität C3 und einen dazu parallel geschalteten Widerstand R8 gegengekoppelt. Der invertierende Eingang des Operationsverstärkers OP6 ist über einen Widerstand R12 mit dem Ausgang des Operationsverstärkers OP5 verbunden, dessen invertierender Eingang wiederum zum einen über einen Widerstand R9 mit dem Ausgang des Operationsverstärkers OP4 gekoppelt ist und zum anderen über einen Widerstand R7 mit dem Anregungssignal, nämlich dem Referenzsignal REF, beaufschlagt ist. Der invertierende Eingang des Operationsverstärkers OP4 ist über einen Widerstand R11 mit dem Ausgang des Operationsverstärkers OP6 gekoppelt, der gleichzeitig auch den Ausgang des Vergleichsnetzwerkes CNW bildet und somit das Antwortsignal führt.

Das analoge Signalnetzwerk SNW besteht ebenfalls aus drei Operationsverstärkern OP1, OP2 und OP3, deren nichtinvertierende Eingänge auf dem Bezugspotential liegen. Der Operationsverstärker OP1 ist über einen Widerstand R3, der Operationsverstärker OP2 über eine Kapazität C1 und der Operationsverstärker OP3 über eine Kapazität C2 und einen dazu parallel geschalteten Widerstand R5 zwischen Ausgang und invertierendem Eingang gegengekoppelt. Der invertierende Eingang des Operationsverstärkers OP1 ist über einen Widerstand R4 mit dem Ausgang des Operationsverstärkers OP3 verbunden, dessen invertierender Eingang wiederum über einen Widerstand R6 mit dem Ausgang des Operationsverstärkers OP2 gekoppelt ist. Der invertierende Eingang des Operationsverstärkers OP2 ist über einen Widerstand R2 an den Ausgang des Operationsverstärkers OP1 und über einen Widerstand R1 an ein analoges Signal AS1 angeschlossen. Dem Ausgang des Operationsverstärkers OP3 ist der Analog-Digital-Wandler ADC nachgeschaltet, dem das digitale Signalnetzwerk DNW folgt.

Als digitales Singalnetzwerk DNW ist beim vorliegenden Ausführungsbeispiel ein nichtrekursives Digitalfilter, ein FIR-Filter, vorgesehen, das fünf in Reihe geschaltete Verzögerungselemente D1...D5 aufweist. Die Ausgänge aller Verzögerungselemente D1...D5 sowie der Eingang des ersten Verzögerungselementes D1 sind jeweils paarweise derart miteinander gekoppelt, daß der Eingang des ersten Verzögerungselementes D1 und der Ausgang des letzten Verzögerungselementes D5, der Eingang des zweiten Verzögerungselementes D2 und der Ausgang des vierten Verzögerungselementes D4 sowie der Eingang und der Ausgang des dritten Verzögerungselementes D3 jeweils mit den Eingängen eines Addierers A1, A2, A3 verschaltet sind, deren Ausgänge unter Zwischenschaltung jeweils eines Multiplizierers M1, M2, M3 auf die Eingänge eines die Addierers A4 geführt sind. Dessen Ausgang bildet den Ausgang des digitalen Signalnetzwerkes DNW, der ein digitales Signal DS1 führt. An den jeweils weiteren Eingängen der Multiplizierer M1, M2, M3 sind die Koeffizienten K1, K2, K3 angelegt.

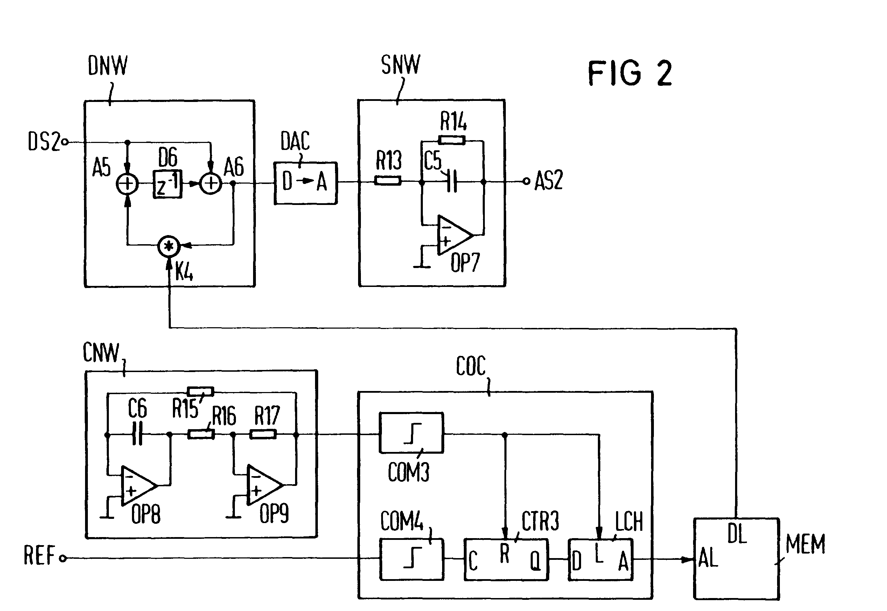

Das Ausführungsbeispiel nach Figur 2 ist gegenüber dem nach Figur 1 dahingehend abgeändert, daß das digitale Signalnetzwerk DNW eingangsseitig mit einem Digitalsignal DS2 beaufschlagt ist, daß dem digitalen Signalnetzwerk DNW ein Digital-Analog-Wandler DAC nachgeschaltet ist und daß diesem das analoge Signalnetzwerk SNW folgt. Außerdem ist das digitale Signalnetzwerk DNW als rekursives Digitalfilter ausgeführt, das ein Verzögerungselement D6 aufweist. Das Verzögerungselement D6 ist einem Addierer A5 nachgeschaltet, dessen einer Eingang mit dem Digitalsignal DS2 beaufschlagt ist und dessen anderer Eingang mit dem Ausgang eines Multiplizierers M4 verbunden ist. Ein Eingang des Multiplizierers M4 ist mit dem Ausgang eines Addierers A6 gekoppelt, dessen einer Eingang mit dem Digitalsignal DS2 beaufschlagt ist und dessen anderer Eingang mit dem Ausgang des Verzögerungselementes D6 gekoppelt ist. An den weiteren Eingang des Multiplizierers M4 ist ein Koeffizient K4 angelegt. An den Ausgang des Addierers A6 ist zudem der Eingang des Digital-Analog-Wandlers DAC angeschlossen.

Das analoge Signalnetzwerk SNW enthält einen Operationsverstärker OP7, dessen nichtinvertierender Eingang auf dem Bezugspotential liegt und der zwischen Ausgang und invertierendem Eingang über einen Widerstand R14 und eine parallel dazu geschaltete Kapazität C5 rückgekoppelt ist. Der invertierende Eingang des Operationsverstärkers OP7 ist darüber hinaus über einen Widerstand R13 mit dem Ausgang des Digital-Analog-Wandlers DAC verbunden. Am Ausgang des Operationsverstärkers OP7, der den Ausgang des analogen Signalnetzwerkes SNW bildet, liegt ein analoges Signal AS2 an.

Der Koeffizient K4 für das digitale Signalnetzwerk DNW wird durch den Speicher MEM über seine Datenleitungen DL bereitgestellt. Die Auswahl des entsprechenden Speicherplatzes erfolgt wiederum über die Adreßleitungen AL, die an den Ausgang der Auswerteschaltung COC angeschlossen sind. Die Auswerteschaltung COC beinhaltet beim Ausführungsbeispiel nach Figur 2 einen digitalen Frequenzvergleicher, der im wesentlichen einen Zähler CTR3 und ein Latch LTH aufweist. An den Rücksetzeingang R des Zählers CTR sowie an einen Steuereingang L des Speicherelementes LCH ist das Antwortsignal des Vergleichsnetzwerkes CNW gelegt. Der Zähleingang des Zählers CTR ist mit dem Referenzsignal REF beaufschlagt. Des weiteren sind zwei Komparatoren COM3, COM4 vorgesehen, welche zur Erhöhung der Flankensteilheit des Antwortsignals des Vergleichsnetzwerkes CNW und des Referenzsignals REF dem Rücksetzeingang des Zählers CTR3 und des Steuereingangs L des Speicherelementes LCH bzw. dem Zähleingang C des Zählers CTR3 vorgeschaltet sind.

Das Vergleichsnetzwerk CNW ist beim Ausführungsbeispiel nach Figur 2 durch eine Oszillatorschaltung gegeben. Die Oszillatorschaltung besteht aus zwei Operationsverstärkern OP8 und OP9, deren nichtinvertierende Eingänge auf Bezugspotential liegen. Der nichtinvertierende Eingang und der Ausgang sind beim Operationsverstärker OP8 über eine Kapazität C6 und beim Operationsverstärker OP9 über einen Widerstand R17 miteinander gekoppelt. Der Ausgang des Operationsverstärkers OP9 ist zudem über einen Widerstand R15 mit dem nichtinvertierenden Eingang des Operationsverstärkers OP8 verbunden, dessen Ausgang wiederum über einen Widerstand R16 mit dem invertierenden Eingang des Operationsverstärkers OP9 gekoppelt ist. Am Ausgang des Operationsverstärkers OP9 liegt das Antwortsignal des analogen Vergleichsnetzwerkes CNW an, das gleichzeitig auch das Anregungssignal darstellt.

Bei einer erfindungsgemäßen Schaltungsanordnung wird immer von einem gemischten analogen/digitalen System ausgegangen. Um den dabei notwendigen Analog-Digital-Wandler bzw. Digital-Analog-Wandler werden jeweils zwei aufeinander abgestimmte Signalnetzwerke angeordnet, von denen das eine analog und das andere digital realisiert ist. Das digitale Signalnetzwerk DNW wird immer so eingestellt, daß es die Schwankungen des analogen Signalnetzwerkes SNW ausgleicht und das Gesamtübertragungsverhalten konstant gehalten wird. Dazu werden die Schwankungen des Übertragungsverhaltens des analogen Signalnetzwerkes SNW bestimmt. Dies geschieht mittels des analogen Vergleichsnetzwerkes CNW, dessen Ubertragungsverhalten sich proportional zu dem des Signalnetzwerkes SNW verändert. Die Änderungen im Ubertragungsverhalten des analogen Vergleichsnetzwerkes CNW werden mittels der Auswerteschaltung COC ermittelt und daraufhin der bzw. die Koeffizienten des digitalen Signalnetzwerkes DNW entsprechend geändert. Es handelt sich dabei also um einen Steuerkreis, im Gegensatz zu der bekannten Anordnung, bei der es sich um einen Regelkreis, genauer gesagt um einen Phasenregelkreis, handelt. Darüber hinaus wird bei der erfindungsgemäßen Schaltungsanordnung wiederum im Gegensatz zur bekannten Anordnung die analogen Netzwerke, das Signalnetzwerk SNW und das Vergleichsnetzwerk CNW, nicht verändert. Die verwendeten Widerstände R1...R17 sind also nicht steuerbar. Diese Widerstände R1...R17 sind abgesehen von temperatur- und produktionsbedingten Schwankungen insofern als konstant anzusehen.

Der Aufbau des analogen Signalnetzwerkes SNW ist prinzipiell beliebig und hängt im wesentlichen vom jeweiligen Anwendungsfalls ab. Das bedeutet, daß neben den gezeigten Ausführungsformen mit Tiefpassverhalten eine Vielzahl weiterer Ausführungsformen möglich sind, die sich beispielsweise im Übertragungsverhalten und/oder der schaltungstechnischen Realisierung unterscheiden. So ist neben der gezeigten unsymmetrischen ebenso eine symmetrische Ausbildung des Signalnetzwerkes SNW möglich.

In gleicher Weise hängt der Aufbau des Analog-Digital-Wandlers ADC bzw. des Digital-Analog-Wandlers DAC in weiten Bereichen vom jeweiligen Anwendungsfall ab und soll hier im weiteren nicht näher ausgeführt werden. Prinzipiell sind aber auch hier alle gängigen Wandlertypen einsetzbar.

Ebenso ist das digitale Signalnetzwerk DNW auf vielfältige Wesie realisierbar. Das Übertragungsverhalten des digitalen Filters DF ist auf das Übertragungsverhalten des analogen Signalnetzwerkes SNW abgestimmt. Durch Ändern des bzw. der Koeffizienten K1...K4 wird das Übertragungsverhalten derart beeinflußt, daß die Schwankungen beim Übertragungsverhalten des analogen Signalnetzwerkes SNW ausgeglichen werden. Bei der Realisierung können in gleicher Weise nichtrekursive oder rekursive Strukturen, wie beispielsweise Wellendigitalfilter, verwendet werden.

Die Einstellung der Koeffizienten K1...K4 soll in Abhängigkeit von den Schwankungen des analogen Signalnetzwerkes SNW erfolgen. Die Schwankungen des analogen Signalnetzwerkes SNW werden dabei aber nicht direkt gemessen, sondern es werden stattdessen die Schwankungen des Vergleichsnetzwerkes CNW ermittelt. Dabei wird davon ausgegangen, daß die Schwankungen des Vergleichsnetzwerkes CNW proportional zu den Schwankungen des analogen Signalnetzwerkes SNW sind. Das heißt also, daß das Vergleichnetzwerk CNW in gleicher Weise den Schwankungen unterworfen ist wie das analoge Signalnetzwerk SNW. Um einen Gleichlauf der Schwankungen zu erzielen, werden beispielsweise das Ubertragungsverhalten bestimmende Widerstände R1...R17 und Kapazitäten C1...C6 bei Signalnetzwerk SNW und Vergleichsnetzwerk CNW identisch ausgeführt. Unterschiedliche Widerstands- und Kapazitätswerte werden dabei durch Parallel- bzw. Reihenschaltung gleicher Elemente erzeugt. Die relative Genauigkeit und der Gleichlauf der einzelnen Elemente untereinander ist bei der Realisierung in integrierter Technik im allgemeinen von Hause aus sehr hoch. Signalnetzwerk SNW und Vergleichsnetzwerk CNW müssen allerdings nicht ein identisches Übertragungsverhalten aufweisen. So kann es sich beispielsweise beim Signalnetzwerk SNW auch um ein Tiefpaßfilter handeln, während es sich beim Vergleichsnetzwerk CNW um ein Bandpaßfilter oder um ein Rückkopplungsnetzwerk eines Oszillators mit Bandpaßverhalten handelt.

Zur Ermittlung der Schwankungen des Vergleichsnetzwerkes CNW mißt die Auswerteschaltung COC eine für die Schwankung des Übertragungsverhaltens charakteristische Größe. Diese charakteristische Größe ist bei dem Ausführungsbeispiel nach Figur 1 die Phase und bei dem Ausführungsbeispiel nach Figur 2 die Frequenz des Antwortsignals des Vergleichsnetzwerkes CNW. Bei der Phasenmessung wird davon ausgegangen, daß im Durchlaßbereich eines Bandpasses die Phasenverschiebung gleich Null ist. Wird nun der Bandpaß als analoges Vergleichsnetzwerk CNW mit dem Referenzsignal REF angesteuert und anschließend das Antwortsignal mit diesem verglichen, so können Änderungen des Durchlaßbereiches aufgrund von Änderungen der Widerstands- und Kapazitätswerte als Phasenverschiebung festgestellt werden. Dagegen wird bei dem Ausführungsbeispiel nach Figur 2 die Frequenz eines Oszillators gemessen, der als frequenzbestimmende Elemente einen Widerstand und Kapazität aufweist. Durch die Auswerteschaltung COC wird hierbei die Frequenz des Oszillators im Bezug auf die Frequenz des Referenzsignals REF ermittelt und es werden somit Änderungen der Widerstands- und Kapazitätswerte als Frequenzänderungen festgestellt.

In Weiterbildung der Erfindung ist die Auswerteschaltung COC als digitale Phasenvergleicher bzw. Frequenzvergleicher ausgeführt, die unter anderem einen oder mehrere Zähler aufweisen. Die Phasen- bzw. Frequenzunterschiede werden dabei jeweils als digitale Größe ausgegeben. Das hat den Vorteil, daß kein zusätzlicher Analog-Digital-Wandler benötigt wird und der schaltungstechnische Aufwand damit insgesamt sehr gering ist.

Durch Verwendung des Speichers MEM, der den von der Auswerteschaltung COC ermittelten Wert der Schwankung in eine entsprechende Änderung des bzw. der Koeffizienten K1...K4 umsetzt, ist eine Abstimmung des digitalen Signalnetzwerkes DNW auf das analoge Signalnetzwerk SNW zum einen leicht maschinell, insbesondere rechnergesteuert, durchführbar und zum anderen ist damit eine hohe absolute Genauigkeit erzielbar.

Darüber hinaus zeichnet sich eine erfindungsgemäße Schaltungsanordnung durch einen sehr geringen analogen Schaltungsaufwand, und aufgrund der überwiegend digital realisierten Funktionen durch eine große Reproduzierbarkeit aus. Außerdem sind Rückwirkungen auf den Signalzweig äußerst gering, da wergen der Verwendung eines Steuerkreises anstelle eines Regelkreises Einschwingverhalten und Regelverhalten entfallen und somit keinen Einfluß auf den Signalzweig haben.

Abschließend sei daraufhingewiesen, daß die Auswerteschaltung COC bevorzugt Hystereseverhalten aufweist. Dazu sind beispielsweise die Zähler CTR1, CTR2, CTR3 oder der Subtrahierer SUB entsprechend ausgebildet. Bei einer Änderung des Übertragungsverhaltens des analogen Vergleichsfilters CNW erfolgt erst ab einem bestimmten Schwellenwert auch eine Änderung der Adressen auf den Adressleitungen AL. Der Schwellenwert ist dabei, wie bei Hystereseverhalten üblich, je nach Richtung der Änderung unterschiedlich. Außerdem sind darüber hinaus die analogen Signalnetzwerke außer mit den digitalen Netzwerken zusätzlich auch mit Switched-Capacitor-Netzwerken, die ebenfalls durch die Auswerteschaltung gesteuert werden, kombinierbar.

## Patentansprüche

1. Integrierbare Schaltungsanordnung
mit einem Schwankungen unterworfenen analogen Signalnetzwerk (SNW),
mit einem dem analogen Signalnetzwerk (SNW) nachgeschalteten Analog-Digital-Wandler (ADC),
mit einem dem Analog-Digital-Wandler (ADC) nachgeschalteten digitalen Signalnetzwerk (DNW) mit einstellbaren Koeffizienten (K1, K2, K3),
mit einem den Schwankungen in gleicher Weise unterworfenen analogen Vergleichsnetzwerk (CNW), an das ein Anregungssignal angelegt ist, und
mit einer Auswerteschaltung (COC), die ein vom analogen Vergleichsnetzwerk (CNW) aufgrund des Anregungssignals abgegebenes Antwortsignal mit einem Referenzsignal (REF) vergleicht und davon abhängig die Koeffizienten (K1, K2, K3) des digitalen Signalnetzwerkes (DNW) einstellt.

2. Integrierbare Schaltungsanordnung
mit einem Schwankungen unterworfenen analogen Signalnetzwerk (SNW),
mit einem dem analogen Signalnetzwerk (SNW) vorgeschalteten Digital-Analog-Wandler (DAC),
mit einem dem Digital-Analog-Wandler (DAC) vorgeschalteten digitalen Signalnetzwerk (DNW) mit einstellbaren Koeffizienten (K1, K2, K3),
mit einem den Schwankungen in gleicher Weise unterworfenen analogen Vergleichsnetzwerk (CNW), an das ein Anregungssignal angelegt ist, und
mit einer Auswerteschaltung (COC), die ein vom analogen Vergleichsnetzwerk (CNW) aufgrund des Anregungssignals abgegebenes Antwortsignal mit einem Referenzsignal (REF) vergleicht und davon abhängig die Koeffizienten (K1, K2, K3) des digitalen Signalnetzwerkes (DNW) einstellt.

3. Schaltungsanordnung nach Anspruch 1 oder 2,
**gekennzeichnet durch** einen zwischen Auswerteschaltung (COC) und digitales Signalnetzwerk (DNW) geschalteten Speicher (MEM), in dem unterschiedliche Werte für die Koeffizienten (K1...K4) abgelegt sind, wobei zur Einstellung der Koeffizienten (K1...K4) des digitalen Signalnetzwerkes (DNW) jeweils bestimmte Werte durch die Auswerteschaltung (COC) ausgewählt werden.

4. Schaltungsanordnung nach einem der Ansprüche 1 bis 3,
**gekennzeichnet durch** einen Bandpaß (OP3, OP4, OP5, R7...R12, C3, C4) als analoges Vergleichsnetzwerk (CNW), an den als Anregungssignal das Referenzsignal (REF) angelegt ist.

5. Schaltungsanordnung nach einem der Ansprüche 1 bis 3,
**dadurch gekennzeichnet,** daß das analoge Vergleichsnetzwerk (CNW) durch eine Oszillatorschaltung (OP8, OP9, C6, R15, R16, R17) gegeben ist, bei der das Anregungssignal gleich dem Antwortsignal ist.

6. Schaltungsanordnung nach Anspruch 4,
**dadurch gekennzeichnet,** daß die Auswerteschaltung (COC) einen digitalen Phasendetektor (CTR1, CTR2, SUB) aufweist.

7. Schaltungsanordnung nach Anspruch 5,
**dadurch gekennzeichnet,** daß die Auswerteschaltung (COC) einen digitalen Frequenzdetektor (CTR3, LCH) aufweist.

8. Schaltungsanordnung nach einem der Ansprüche 1 bis 7,
**dadurch gekennzeichnet,** daß analoges Signalnetzwerk (SNW) und analoges Vergleichsnetzwerk (CNW) identisch aufgebaute Widerstände (R1...R17) und Kapazitäten (C1...C6) enthalten.

## Claims

1. Integrable circuit arrangement
having an analog signal network (SNW) that is subjected to fluctuations,
having an analog-to-digital converter (ADC) connected downstream of the analog signal network (SNW),
having a digital signal network (DNW) which is connected downstream of the analog-to-digital converter (ADC) and has coefficients (K1, K2, K3) that can be set,
having an analog comparison network (CNW) which is subjected to fluctuations in the same way and to which an excitation signal is applied, and
having an evaluation circuit (COC), which compares a response signal, which is emitted by the analog comparison network (CNW) on account of the excitation signal, with a reference signal (REF) and, as a function thereof, sets the coefficients (K1, K2, K3) of the digital signal network (DNW).

2. Integrable circuit arrangement
having an analog signal network (SNW) that is subjected to fluctuations,
having an digital-to-analog converter (DAC) connected upstream of the analog signal network (SNW),
having a digital signal network (DNW) which is connected upstream of the digital-to-analog converter (DAC) and has coefficients (K1, K2, K3) that can be set,
having an analog comparison network (CNW) which is subjected to fluctuations in the same way and to which an excitation signal is applied, and
having an evaluation circuit (COC), which compares a response signal, which is emitted by the analog comparison network (CNW) on account of the excitation signal, with a reference signal (REF) and, as a function thereof, sets the coefficients (K1, K2, K3) of the digital signal network (DNW).

3. Circuit arrangement according to Claim 1 or 2, characterized by a memory (MEM), which is connected between evaluation circuit (COC) and digital signal network (DNW) and in which different values for the coefficients (K1...K4) are stored, specific values in each case being selected by the evaluation circuit (COC) for the purpose of setting the coefficients (K1...K4) of the digital signal network (DNW).

4. Circuit arrangement according to one of Claims 1 to 3,
characterized by a bandpass filter (OP3, OP4, OP5, R7...R12, C3, C4) as analog comparison network (CNW), to which filter the reference signal (REF) is applied as excitation signal.

5. Circuit arrangement according to one of Claims 1 to 3,
characterized in that the analog comparison network (CNW) is provided by an oscillator circuit (OP8, OP9, C6, R15, R16, R17), in which the excitation signal is identical to the response signal.

6. Circuit arrangement according to Claim 4,
characterized in that the evaluation circuit (COC) has a digital phase detector (CTR1, CTR2, SUB).

7. Circuit arrangement according to Claim 5,
characterized in that the evaluation circuit (COC) has a digital frequency detector (CTR3, LCH).

8. Circuit arrangement according to one of Claims 1 to 7,
characterized in that the analog signal network (SNW) and the analog comparison network (CNW) contain identically constructed resistors (R1...R17) and capacitors (C1...C6).

## Revendications

1. Montage intégrable comprenant
un réseau de signaux analogique (SNW) soumis à des fluctuations,
un convertisseur analogique-numérique (ADC) connecté en aval du réseau de signaux analogique (SNW),
un réseau de signaux numérique (DNW) à coefficients ajustables (K1, K2, K3), connecté en aval du convertisseur analogique-numérique (ADC),
un réseau comparateur analogique (CNW) soumis aux fluctuations de la même façon, auquel est appliqué un signal d'excitation et
un circuit d'analyse (COC) qui compare un signal de réponse issu du réseau comparateur analogique (CNW) en réponse au signal d'excitation, avec un signal de référence (REF) et ajuste les coefficients (K1, K2, K3) du réseau de signaux numérique (DNW) en fonction de cette comparaison.

2. Montage intégrable comprenant
un réseau de signaux analogique (SNW) soumis à des fluctuations,
un convertisseur numérique-analogique (DAC) connecté en amont du réseau de signaux analogique (SNW),
un réseau de signaux numérique (DNW) à coefficients ajustables (K1, K2, K3), connecté en amont du convertisseur numérique-analogique (DAC),
un réseau comparateur analogique (CNW) soumis aux fluctuations de la même façon, auquel est appliqué un signal d'excitation, et
un circuit d'analyse (COC) qui compare un signal de réponse issu du réseau comparateur analogique (CNW) en réponse au signal d'excitation avec un signal de référence (REF) et ajuste les coefficients (K1, K2, K3) du réseau de signaux numérique (DNW) en fonction de cette comparaison.

3. Montage selon la revendication 1 ou 2,
caractérisé par une mémoire (MEM) connectée entre le circuit d'analyse (COC) et le réseau de signaux numérique (DNW) et dans laquelle sont enregistrées différentes valeurs pour les coefficients (K1...K4), des valeurs déterminées étant sélectionnées à chaque fois par le circuit d'analyse (COC) pour l'ajustement des coefficients (K1...K4) du réseau de signaux numérique (DNW).

4. Montage selon une des revendications 1 à 3,
caractérisé par un passe-bande (OP3, OP4, OP5, R7...R12, C3, C4) utilisé comme réseau comparateur analogique (CNW), auquel le signal de référence (REF) est appliqué en tant que signal d'excitation.

5. Montage selon une des revendications 1 à 3,
caractérisé en ce que le réseau comparateur analogique (CNW) est constitué par un circuit oscillateur (OP8, OP9, C6, R15, R16, R17) dans lequel le signal d'excitation est égal au signal de réponse.

6. Montage selon la revendication 4,
caractérisé en ce que le circuit d'analyse (COC) comprend un détecteur de phase numérique (CTR1, CTR2, SUB).

7. Montage selon la revendication 5,
caractérisé en ce que le circuit d'analyse (COC) comprend un détecteur de fréquence numérique (CTR3, LCH).

8. Montage selon une des revendications 1 à 7,
caractérisé en ce que le réseau de signaux analogique (SNW) et le réseau comparateur analogique (CNW) comprennent des résistances (R1...R17) et des capacités (C1...C6) de construction identique.
